# EUROPEAN PATENT SPECIFICATION

(11) **EP 0 699 709 B1**
(45) Date of publication and mention of the grant of the patent: **16.06.1999**
(21) Application number: 93908113.9
(22) Date of filing: 19.04.1993
(51) Int. Cl.: C08L 21/00, C08K 3/22, C08K 7/18, C08K 9/08, B01J 2/28, H01L 41/18, H01L 41/22, C04B 35/49

(54) **METHOD FOR MANUFACTURING ULTRA-FINE PIEZOELECTRIC CERAMIC PARTICLES FOR PIEZOELECTRIC ELASTOMERS**
VERFAHREN ZUR HERSTELLUNG VON ULTRAFEINEN PIEZOELEKTRISCHEN KERAMIKPARTIKELN FÜR PIEZOELEKTRISCHE ELASTOMERE
PROCEDE DE FABRICATION DE PARTICULES ULTRA-FINES EN CERAMIQUE PIEZOELECTRIQUE POUR ELASTOMERES PIEZOELECTRIQUES

(43) Date of publication of application: 06.03.1996
(73) Proprietor: Kabushiki Kaisha Meiji Gomu Kasei, Shinjuku-ku, Tokyo 160 (JP)
(72) Inventor: IGARASHI, Syuji, Kanagawa-ken 239 (JP); HISAMOTO, Syuzo Akishima Laboratory Mitsui Engine, 1-chome Akishima-shi Tokyo 196 (JP); HIRANO, Katsunori Kanagawa Factory Kabushiki Kais, arakami-gun Kanagawa-ken 258 (JP); IWATA, Chiharu Kanagawa Factory Kabushiki Kaisha, akami-gun Kanagawa-ken 258 (JP)
(74) Representative: Godwin, Edgar James
(86) International application number: JP9300504
(87) International publication number: WO9424203

(56) References cited:
- JP-A- 53 126 199
- JP-A- 56 164 812
- JP-A- 57 092 577
- JP-A- 58 183 936
- JP-A- 60 120 579
- JP-A- 63 007 677
- PATENT ABSTRACTS OF JAPAN vol. 017, no. 400 (C-1089), 27 July 1993 & JP-A-05 076746 (MITSUI ENG & SHIPBUILD CO LTD;OTHERS: 01), 30 March 1993,

## Description

### Field of the Invention

A piezoelectric elastomer capable of detecting pressure levels is a composite material comprising an elastomer and a piezoelectric ceramic material. The present invention relates to a method for manufacturing ultra-fine particles of sintered piezoelectric ceramic to be filled in the elastomer. More particularly, it relates to a method for manufacturing ultra-fine particles of piezoelectric ceramic such as lead titanate zirconate, of which particle diameter can be controlled to fall within a given range and which are suitable for use in piezoelectric elastomer.

### Technical Background

Piezoelectric elastomers and ceramics develop a voltage that corresponds to the level of stress applied or generate a mechanical force when applied with a voltage. As such, they are extensively used in pickups for musical instruments, underwater sonar elements, word-processor keyboards, speakers and actuators. A piezoelectric elastomer is obtained by uniformly dispersing piezoelectric ceramic powder in an elastomer such as silicone rubber, natural rubber and chloroprene rubber.

According to the conventional method, piezoelectric ceramic powder is manufactured by the following steps. As shown in Fig. 9, a stock powder of piezoelectric ceramic is calcinated at 700 - 900°C and then sintered at a higher temperature within the range of from 1100°C to 1300°C. Electric furnaces are usually used for said calcination and sintering because of ease of automatically controlling the temperature. After sintering, the stock material is mechanically crushed using a hammer mill e.g., and mixed with elastomer.

As crushing alone fails to produce particles of uniform size, the sintered ceramic powder is further pulverized according to wet or dry process using such means as ball mill, roll mill or jet mill and classified to obtain a ceramic powder of uniform particle size.

In order to produce a high quality piezoelectric elastomer, the piezoelectric ceramic powder must be uniformly filled in the elastomer at a high filling ratio. Piezoelectric ceramic powder filled at a high ratio and distributed uniformly in the elastomer improves polarization efficiency of the resultant piezoelectric elastomer to thereby improve the piezoelectric characteristics.

However, conventional piezoelectric ceramic powder obtained by mechanical pulverization such as that mentioned above has the following defects.

Sintered ceramics are intrinsically hard and are therefore difficult to pulverize. Because of mere mechanical crushing, particles have irregular shapes and are distributed over a wide range of sizes. Moreover, sharp edges are formed on the outer periphery of the particles. Thus, it was not only impossible to uniformly distribute the conventional piezoelectric ceramic powder in the elastomer but also difficult to fill the same at a high ratio. Accordingly, characteristics of the resultant piezoelectric elastomer varied greatly.

Although it is possible to adjust the particle size to fall within a given range by classification, classification itself brings about a substantial material loss because the particle sizes are widely distributed. Furthermore, the piezoelectric ceramic powders after classification cannot be reused once they have been sintered, leading to cost increase coupled with material loss.

As piezoelectric ceramic powder obtained by the conventional mechanical pulverization cannot be uniformly dispersed and filled in the elastomer at a high ratio, the resultant piezoelectric elastomer fails to exhibit high quality.

It is therefore an object of the present invention to provide a method for manufacturing ultra-fine particles of piezoelectric ceramic which can be dispersed uniformly and thus filled at a high ratio.

Another object of the present invention is to provide a method for manufacturing ultra-fine particles of piezoelectric ceramic that are uniform in size.

Still another object of the present invention is to provide a method for manufacturing ultra-fine particles of piezoelectric ceramic having curved surfaces.

JP-A-05 076746 discloses a method for preparing piezoelectric microspheres, in which calcinated powder of piezoelectric ceramic, such as lead titanate zirconate, is mixed with a binder. The mixture is sieved before being formed into microspheres by shaking. After drying and dehydrating, the microspheres are sintered.

### Disclosure of the Invention

According to the present invention, as set forth in claims 1 and 2, piezoelectric ceramic is calcinated to obtain powder, to which is blended a binder, a dispersant, and a dispersion solvent. The resultant mixture is then formed by spray drying into ultra-fine particles with curved surfaces, and is dried and dehydrated before being sintered. Surfaces of the sintered particles are all curved, so that the particles disperse well in the elastomer at a high filling ratio.

According to the present invention, the powder mixture is made into a slurry, whereby continuous granulation becomes possible using a spray dryer.

If the particles are classified before being sintered, it is possible to reuse the powder.

The ultra-fine particles preferably have diameters within the range 10 to 1000 micrometers.

### Brief Description of the Drawings

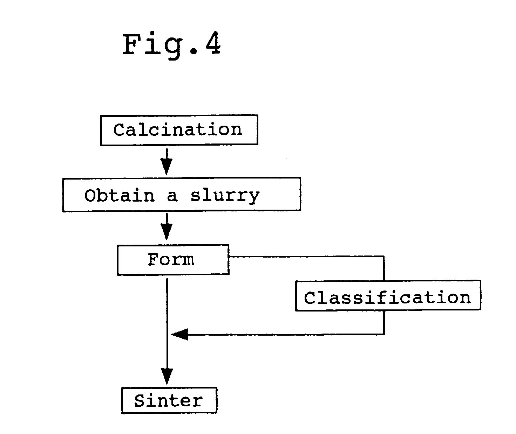

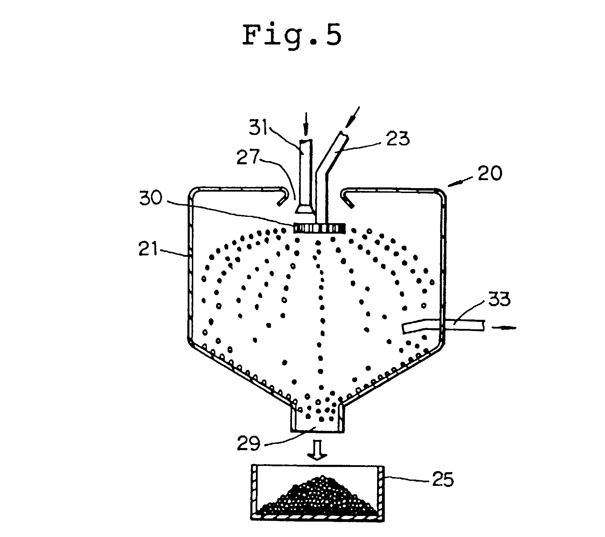

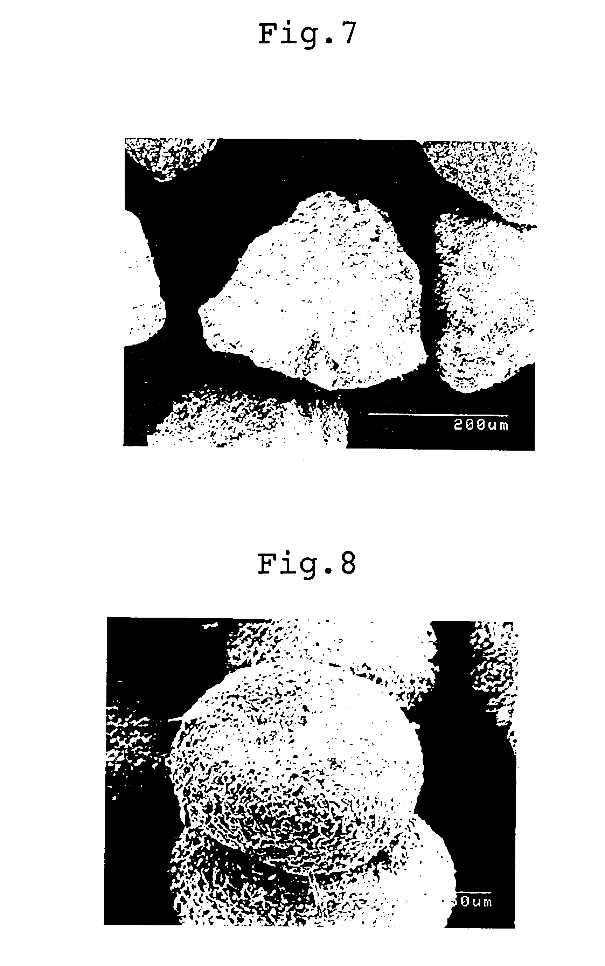

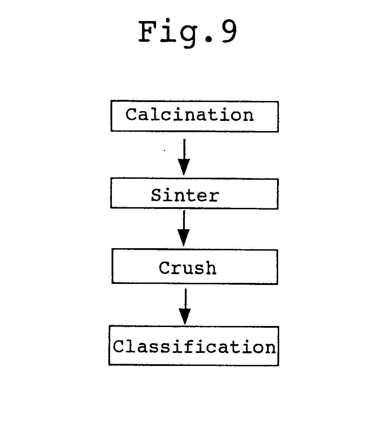

Fig 4 is a flow chart to show the present invention method using a preferred spray dryer method. Fig. 5 is an explanatory front view to show one embodiment of a spray dryer device used in the spray dryer method. Fig. 7 is a micrograph of sintered lead titanate zirconate powder obtained by the conventional method. Fig. 8 is a micrograph of sintered lead titanate zirconate piezoelectric ceramic powder obtained by the spray drier method. Fig. 9 is a flow chart to show the conventional method for preparing piezoelectric ceramic powder.

### Preferred Embodiments of the Present Invention

The present invention will now be described in more detail referring to the drawings.

Binders to be used in the present invention include conventional starches, PVA, dextrin and wax emulsion e.g., which may be used alone or in combination with others. Binders of any kind may be used so long as they can be decomposed and dispersed at a low temperature during calcination and contain no residual inorganic substances. Any known mixing means such as a ball mill may be used.

The calcinated powder of piezoelectric ceramic mixed with a binder, a dispersing agent and a dispersion solvent is pulverized into ultra-fine particles by a method described below.

Ultra-fine particles of a prescribed size can be separated by classification. The particles may be sieved for classification. The classified particles are dried and dehydrated in an oven and then sintered. The sintering method is not particularly specified, and any known method can be employed. For example, an electric furnace can be used to sinter the particles at 1100 - 1300°C for 1 to 3 hours.

Sintering is preferably conducted by raising the temperature at a given rate for a given length of time to allow full growth of the ultra-fine particles of piezoelectric ceramic. Upon completion of the sintering process, ultra-fine particles of uniform shape and size can be obtained.

As shown in Fig. 4, a slurry of calcinated powder of piezoelectric ceramic such as lead titanate zirconate is prepared by thoroughly mixing the powder with a binder, a dispersing agent, and a dispersion solvent.

Polycarboxylic acid base dispersants are preferably used in the present invention. Alcohols or ketones can be used as the dispersion solvent. The dispersion solvent should preferably be able to disperse the calcinated powder of piezoelectric ceramic. These additives can be mixed with the powder by using a known means such as a ball mill.

The slurry obtained from the calcinated piezoelectric ceramic powder is then formed into ultra-fine particles using a spray drier. Fig. 5 is a schematic diagram of the spray drier 20.

The spray drier 20 comprises a granulating column 21, a slurry duct 23 and a receptacle 25. The cylindrically shaped granulating column 21 is funneled at the bottom and has openings 27 and 29 at the top and the bottom respectively. A turbine disk 30 attached to the tip of the slurry duct 23 is inserted through the top opening 27.

An air duct 31 for injecting hot air is also inserted at the top opening 27, and an air exhaust 33 inserted at a Lower side of the column 21. The receptacle 25 is placed directly below the bottom opening 29 to receive the ultra-fine particles granulated and dried in the column 21.

To obtain ultra-fine particles using the spray drier 20 having the construction mentioned above, the slurry is sprayed into the hot environment of the granulating column 21 from the turbine disk 30 attached to the tip of the slurry duct 23. The temperature inside the granulating column 21 may be controlled by supplying hot air from the air duct 31 and by discharging the same from the exhaust duct 33.

The temperature and supply rate of hot air are determined depending on the size of the granulating column 21 and the size of the particles to be sprayed, so that the ultra-fine particles falling down in the column 21 can be thoroughly dried. The slurry of calcinated piezoelectric ceramic powder is thus granulated into particles of true ball and dried in the hot environment in a continuous manner.

The turbine disk 30 attached at the tip of the slurry duct 23 may be replaced with a pressure nozzle or a two-headed nozzle.

The ultra-fine particles of a prescribed size range thus obtained are separated by classification and then dried, dehydrated and sintered. Upon sintering, ultra-fine particles of piezoelectric ceramic having uniform shape and size can be obtained.

It is noted that the classification may be omitted. It is also possible to classify the particles before or after drying/dehydration so long as it is prior to sintering. Because sintering is conducted after the granulation process in the present invention, the ultra-fine particles prior to sintering can be reused with/without pulverization.

In the prior art, because particles were pulverized and classified after the sintering process, it was not possible to reuse those particles falling outside the classified size range, causing material loss. However, the particles according to the present invention can be classified before they are sintered. This allows reuse of the particles and thus reduces material loss.

It is noted that the present invention ultra-fine particles need not be a perfect sphere in shape but may be somewhat elongated in side view so long as all the angular edges are rounded.

Fig. 7 shows a micrograph of the prior art particles of sintered lead titanate zirconate. The present invention particles are spherical with rounded outer peripheral surfaces, while the prior art particles have rugged edges, demonstrating that they are mechanically crushed.

### Example

A specific example of the present invention method using a spray drier will be explained. Calcinated powder of lead titanate zirconate was added with pure water, a dispersant and PVA solution. For every 5 kg of the calcinated powder, 10 g of dispersant, 3480 g of pure water and 750 g of PVA solution were added. The mixture was thoroughly stirred and mixed in a ball mill for 24 hours to obtain a slurry of 55% concentration. The slurry thus obtained was sprayed using a turbine disk at 8000 rpm.

Ultra-fine particles of lead titanate zirconate measuring 10 to 100 µm in diameter were obtained. The particles were classified using a sieve, and the classified particles were sintered at a high temperature in an electric furnace. Ultra-fine particles of sintered lead titanate zirconate measuring 30 to 70 µm were obtained.

Fig. 8 shows a micrograph of ultra-fine particles of sintered lead titanate zirconate obtained by the spray drier method. The resultant particles are substantially spherical with rounded outer peripheral surfaces without sharp edges seen in the prior art particles.

### Field of Industrial Application

As has been described in detail, the present invention method produces sintered particles of piezoelectric ceramic having uniform size for use in a piezoelectric elastomer. Because the particles have no sharp edges, they can be easily dispersed in the elastomer, enabling filling of the elastomer with the particles at a high ratio. The resultant piezoelectric elastomer will have stable piezoelectric characteristics and improved polarization efficiency and can be employed in a wide range of uses such as pickups for musical instruments and for underwater sonar elements.

Moreover, as classification can be conducted before sintering, particles falling outside the prescribed size range can be reused elsewhere to minimize material loss.

## Claims

1. A method for preparing ultra-fine particles of piezoelectric ceramic for use in a piezoelectric elastomer, wherein:
(a) calcinated powder of piezoelectric ceramic, such as lead titanate zirconate, is stirred and mixed with a binder, a dispersant, and a dispersion solvent;
b) the slurry obtained is formed into ultra-fine particles using a spray drier;
(c) the ultra-fine particles are dried and dehydrated; and
(d) the dried and dehydrated ultra-fine particles are sintered.

2. A method for preparing a piezoelectric elastomer, wherein
(a) calcinated powder of piezoelectric ceramic, such as lead titanate zirconate, is stirred and mixed with a binder, a dispersant, and a dispersion solvent;
b) the slurry obtained is formed into ultra-fine particles using a spray drier;
(c) the ultra-fine particles are dried and dehydrated;
(d) the dried and dehydrated ultra-fine particles are sintered; and
(e) uniformly dispersing the sintered particles in an elastomer such as silicone rubber, natural rubber, or chloroprene rubber.

3. A method as claimed in claim 1 or 2, wherein the ultra-fine particles are classified before being sintered.

4. A method as claimed in claim 3, wherein ultra-fine particles separated out by classification are re-used in step (a).

5. A method as claimed in any of claims 1 to 4. wherein the ultra-fine particles have diameters within the range 10 to 1000 micrometers.

## Patentansprüche

1. Verfahren zur Herstellung von ultrafeinen Teilchen aus piezoelektrischer Keramik zur Verwendung in einem piezoelektrischen Elastomer, gemäß welchem:
(a) gebranntes Pulver aus piezoelektrischer Keramik, wie Zirkonat von Bleititanat, mit einem Bindemittel, einem Dispergiermittel und einem Dispersionslösungsmittel gerührt und gemischt wird;
(b) die erhaltene Aufschlämmung unter Verwendung eines Sprühtrockners zu ultrafeinen Teilchen geformt wird;
(c) die ultrafeinen Teilchen getrocknet und dehydratisiert werden; und
(d) die getrockneten und dehydratisierten ultrafeinen Teilchen gesintert werden.

2. Verfahren zur Herstellung eines piezoelektrischen Elastomers, gemäß welchem:
(a) gebranntes Pulver aus piezoelektrischer Keramik, wie Zirkonat von Bleititanat, mit einem Bindemittel, einem Dispergiermittel und einem Dispersionslösungsmittel gerührt und gemischt wird;
(b) die erhaltene Aufschlämmung unter Verwendung eines Sprühtrockners zu ultrafeinen Teilchen geformt wird;
(c) die ultrafeinen Teilchen getrocknet und dehydratisiert werden;
(d) die getrockneten und dehydratisierten ultrafeinen Teilchen gesintert werden; und
(e) die gesinterten Teilchen gleichmäßig in einem Elastomer, wie Silikonkautschuk, Naturkautschuk oder Chloropren-Kautschuk, dispergiert werden.

3. Verfahren gemäß Anspruch 1 oder 2, gemäß welchem die ultrafeinen Teilchen vor dem Sintern sortiert werden.

4. Verfahren gemäß Anspruch 3, gemäß welchem die ultrafeinen Teilchen, die durch die Sortierung abgetrennt worden sind, in Schritt (a) wiederverwendet werden.

5. Verfahren gemäß irgendeinem der Ansprüche 1 bis 4, gemäß welchem die ultrafeinen Teilchen einen Durchmesser im Bereich von 10 bis 1000 Mikrometer aufweisen.

## Revendications

1. Procédé de préparation de particules ultrafines en céramique piézo-électrique pour une utilisation dans un élastomère piézo-électrique, dans lequel:
(a) une poudre calcinée de céramique piézo-électrique, telle que du zirconate de titanate de plomb, est agitée et mélangée avec un liant, un dispersant et un solvant de dispersion;
(b) la suspension épaisse obtenue est transformée en particules ultrafines en utilisant un séchoir à pulvérisation;
(c) les particules ultrafines sont séchées et déshydratées; et
(d) les particules ultrafines séchées et déshydratées sont frittées.

2. Procédé de préparation d'un élastomère piézo-électrique, dans lequel
(a) une poudre calcinée de céramique piézo-électrique, telle que du zirconate de titanate de plomb, est agitée et mélangée avec un liant, un dispersant et un solvant de dispersion;
(b) la suspension épaisse obtenue est transformée en particules ultrafines en utilisant un séchoir à pulvérisation;
(c) les particules ultrafines sont séchées et déshydratées;
(d) les particules ultrafines séchées et déshydratées sont frittées; et
(e) les particules frittées sont dispersées uniformément dans un élastomère tel qu'un caoutchouc silicone, un caoutchouc naturel ou un caoutchouc chloroprène.

3. Procédé suivant la revendication 1 ou 2, dans lequel les particules ultrafines sont classées avant d'être frittées.

4. Procédé suivant la revendication 3, dans lequel les particules ultrafines séparées par classification sont utilisées de nouveau dans l'étape (a).

5. Procédé suivant l'une quelconque des revendications 1 à 4, dans lequel les particules ultrafines présentent des diamètres dans le domaine allant de 10 à 1000 microns.
